## Europäisches Patentamt
## European Patent Office
## Office européen des brevets

(11) Publication number: **0 213 764**
**A2**

(12)
# EUROPEAN PATENT APPLICATION

(21) Application number: **86305938.2**

(22) Date of filing: **01.08.86**

(51) Int. Cl.4: **H01L 21/48 , H01L 23/48**

The title of the invention has been amended (Guidelines for Examination in the EPO, A-III, 7.3).

(30) Priority: **06.08.85 GB 8519709**

(43) Date of publication of application:
**11.03.87 Bulletin 87/11**

(84) Designated Contracting States:
**AT BE CH DE FR IT LI LU NL SE**

(71) Applicant: **The General Electric Company, p.l.c.**
**1 Stanhope Gate**
**London W1A 1EH(GB)**

(72) Inventor: **Chandler, Nicholas**
**7 Campbell Close**
**Chelmsford Essex(GB)**

(74) Representative: **Hoste, Colin Francis**
**The General Electric Company p.l.c. Central Patent Department (Chelmsford Office)**
**Marconi Research Centre West Hanningfield Road**
**Great Baddow Chelmsford CM2 8HN,**
**Essex(GB)**

(54) **Preparation of fragile sheet-like devices, such as lead frames.**

(57) It is possible to prepare fragile devices by the removal of part of a suitable body of material (by an etching or similar removal process), and this technique is particularly applicable to the formation of lead-frames useful in connection with the packaging of micro-electronic devices such as integrated circuits (chips); starting with a foil or sheet blank of relatively thick, robust material, this material is removed, usually by etching, where it is not required at all (the empty spaces between the leads).

Unfortunately, it is very difficult to start with a thich and robust foil and end with a lead-frame the inner parts of which are sufficiently narrow and delicate for use with a device having a lead count as high as 50 connections per side, when the width of the individual leads at their "fine" end must be as little as 0.05mm (50 microns).

The invention suggests a technique whereby most of the thickness of the material over the whole of the lead-frame foil blank's inner area (where the inner connections to the chip will eventually be) is removed from one face to make a generally robust foil with a centrally-located recess defining a much thinner inner section, the recess is filled with some "fixing" material that will both provide support for and hold in position the thin inner section, and further material is then removed from the other face of the blank so as to form the fine inner parts of the lead-frame, these being firmly supported, and held in place, by the "fixing" material filling what was the recess in the foil.

FIG.2C.

## Preparation of Fragile Devices

This invention concerns the preparation of fragile devices by the removal of part of a suitable body of material (by an etching or similar removal process), and relates particularly, though not exclusively, to the formation of lead-frames useful in connection with the packaging of micro-electronic devices such as integrated circuits.

The main concept of the invention is conveniently described with reference to lead-frames.

As is now well known it is possible to manufacture very complex electronic circuits in the form of "chips", in which the circuit -containing both passive components, such as conductors, resistors and capacitors, and active components, such as diodes, transistors and other semi-conductor devices -is formed on and in the surface of a fingernail-sized chip of silicon. In a Large Scale Integrated device the number of connections in and out of the chip may well be at around the hundred mark, but frequently chip designers are pressing for lead counts of a much greater value -possibly as high as 400. To fit these in within the available space, the actual conductors forming these connections have to be only about a few thou (up to 100 microns) wide; this is on a par with a human hair.

Naturally, the chip, and its connectors, has to be protected, and it is common to encase, or package, the chip, usually in a plastics or ceramic material, to make a larger, stronger article which may relatively safely be handled during the construction of the device of which the chip forms a part. One possible end result is the familiar Dual Inline Package (DIP), an oblong object the size of a LEGO brick with conductor "legs" extending downwardly therefrom along either side by which the DIP may be connected onto a Printed Circuit Board (PCB) via holes therein. Another -used most often where the number of connectors to the chip is large -is the Flat Pack (FP), a square object that has its legs on two or all four sides and extending below and then outwardly so that it can sit on the PCB with its legs flush with, and soldered to, the tracks on the board's surface. Such a result (the DIP or FP) is preferably achieved by packaging the chip together with what is called a "lead-frame" (a framework of "radially" extending conductive leads that are very fine and fragile on the inside, where the 25 micron connections are made from them to special pads on the chip itself, but are much coarser, and more robust, on the outside, where the connections are made to the PCB). The invention is concerned with the preparation of fragile bodies like this lead-frame.

It is common practice to construct a lead-frame by starting with a foil or sheet blank of relatively thick, robust material (robust enough to make the legs of a DIP or FP, say), and to remove this material, usually by etching, where it is not required at all (the empty spaces between legs). Unfortunately, the sheer quantity of material to be removed, coupled with the very significant problems of controlling the removal process so as to remove only what is required to be removed, means that it is very difficult to start with a thick and robust foil and end with a lead-frame the inner parts of which are sufficiently narrow and delicate. In one conventional method, quite suitable for making a Flat Pack lead-frame with only a few -say, four or five -connectors per side (making 16 or 20 in all four sides), the lead-frame blank is masked on either major face so as to define those areas wanted (the connectors, together with a few temporary sections holding the whole together) and unwanted (the spaces between connectors together with the central area where the chip will be), and placed in a bath of chemical etchant material until all the unwanted material has been etched away. The result is a "skeleton" of conductors uniformly as thick as the original sheet (typically 0.1mm -100 microns -or so) but wider on the outside (perhaps 1mm -1000 microns) than on the inside (possibly 0.3mm -300 microns). With a low lead count it is acceptable to form these inner leads with their inner ends free, for their thickness and width make them reasonably rigid. However, with a higher lead count -say 20 to 25 connections per side (making 80 to 100 in all) this is unacceptable, and it is necessary to leave unetched a central, lead-retaining, portion to which each fine lead end is attached by a very narrow neck, then to "fix" the leads by a packaging operation, and finally to chop away the lead-retaining portion (through the narrow necks) so as to leave the tips of the leads free and ready to be connected to the relevant chip pads. Unfortunately, with a lead count that is higher still -say, 50 connections per side (making 200 in all) it becomes necessary to reduce the width of the individual leads at their "fine" end to as little as .05 mm (50 microns), and the sheer mechanics of fixing such fine leads, and then chopping away the lead-retaining portion, becomes almost impossible to manage. The invention seeks to mitigate the problems by providing the "fixing" support for these very fine leads not after they have been formed but before . More specifically, the invention suggests a technique whereby most of the thickness of the material over the whole of the lead-frame foil blank's inner area (where the inner connections to the chip will eventually be) is removed from one face to make a generally robust foil with a centrally-located recess defining a much thinner inner section, the recess is filled with some "fixing" material that will both provide support for and hold in position the thin inner section, and further material is then removed from the other face of the blank so as to form the fine inner parts of the lead-frame, these being firmly supported, and held in place, by the "fixing" material filling what was the recess in the foil. Such a technique is, of course, applicable to the preparation of many devices in which a fragile area is formed by the removal of a part of a more robust area.

In one aspect, therefore, the invention provides a method of fabricating a generally planar, sheet-like, device having a first, robust, area and, contiguous therewith, a second, fragile, area to be constructed by removal of some of the material of which the device consists, in which method:

a) starting with a corresponding generally planar, sheet-like blank, in which both first and second areas are robust, some of the material to be removed from the blank to make the second, fragile, area is so removed from one major face of the blank, to form a recess in the blank;

b) the thus-formed recess is filled with a fixing material, so as to support and fix in place the thin area of blank material constituting the base of the recess; and thereafter

c) the remainder of the material to be removed from the blank to make the second, fragile, area is so removed from the other major face of the blank, so forming the required second, fragile, area supported and fixed by the fixing material and contiguous with the first, robust, area.

The method of the invention can, as stated hereinbefore, be applied in the fabrication of numerous types of device, and examples of these are contact sets for electrical switches, and positional sensors. Nevertheless, it is especially suited to the manufacture of lead-frames, as described above, and is for the most part discussed further hereinafter with reference to such a use.

The inventive method is used in the formation of a generally planar (that is to say, flat), sheet-like, device, and starts with a corresponding generally planar, sheet-like, blank. This blank is a sheet, or foil, of material -thus, an article having an area (and length and breadth dimensions) large relative to its thickness, and so has two major faces (the two "sides" of the sheet).

The material of which the blank is constituted naturally depends upon the nature of the device to be made. For a lead-frame the material must be an electrical conductor, especially one that is sufficiently malleable to allow itself to be shaped by a bending operation (subsequent to the method of the invention the robust area of the blank will be made into the "legs" of the package, and will need to be bent -and perhaps re-bent -out of the sheet plane and into the correct shape). Typical lead-frame materials are- made of a suitable metal; nickel-iron alloys of the KOVAR or INVAR type are very suitable, as are copper and copper-based alloys such as beryllium-copper, phosphor bronze - (an alloy of tin and copper with up to 0.5 wt% phosphorus), and copper-iron-phosporus alloys like OLIN I94.

The device to be fabricated is one having a first area that is robust and -contiguous therewith - (and probably wholly surrounded thereby) -a second area that is fragile. The two terms "robust" and "fragile" are used in a fairly relative sense -the "fragile" area is one that is significantly less robust than the robust area, and vice versa -though where a lead-frame is concerned the "robust" area ends up as the "legs" of the final package, tough enough to withstand handling, while the "fragile" area ends up as extremely fine conductors a hundred or so microns in width.

The method of the invention involves removing material from the second area of the blank (and so making that area fragile). Naturally, the distribution of this removal -where, and how much, material is removed -depends on the type of device. For a lead-frame, however, there are two distinct classes of material to be removed. The first is material removed simply to "thin" the sheet over the whole of the defined, second, area, so that it becomes more suitable for forming into the inner leads of the lead-frame. The second is material removed from between those portions that are to be the leads, so separating each lead from its neighbours. In the first stage it is convenient to thin the blank, from one of its major faces, to roughly half its original thickness, while in the second stage the remaining between-lead blank material is removed from the other major face, so leaving the formed leads flush with this other major face.

Removal of material from the blank is accomplished by any technique suited to the intended device. Thus, the methods of removal include particle ablation and laser trimming, but -especially for lead-frames -chemical etching is the preferred technique. Of course, in this latter case the nature of the etchant will be chosen to fit the blank material; the methods are well known in the Art, and need no detailed comment here -though it may be useful simply to note that nickel iron alloys can best be etched by ferric chloride/hydrochloric acid mixtures, or nitric acid-based materials, while copper and its alloys are preferably dealt with using either ferric chloride or ammoniacal cupric chloride (REGENEX, for instance). It is also worth pointing out that etching (and, indeed, other techniques of material removal) has to be done selectively - some areas are to be removed, some not -and a convenient way to arrange this is to "mask" the areas not to be etched with a protective coating that is unaffected by the etchant to be employed. Within reason -a degree of "undercutting" of the mask is, unfortunately, inevitable, and is the greater as the depth of the etching increases -this will ensure that only the unmasked, exposed, areas are etched away.

In the first stage of the method of the invention material is removed from all over the whole of the second area of the blank (that area destined to become the fragile area of the device), so thinning that area. It is, of course, possible at the same time to remove material from the first area (the area destined to become the robust area of the device). For example, when the device is a lead-frame it is naturally a requirement that the robust area end up as leads the outer part of which make the legs of the final package, so that somewhere along the way there must be removed from the blank's robust area all the material between those portions destined to be these leads. At least some of this surplus material can, then, be removed at the same time as the second area is thinned (when using a through-mask etching technique this is arranged quite simply by so designing the mask that the "between-leg" portions remain exposed). Over the whole of the first area the between-leg portions are consequently subjected to the same thinning as that effected to the second area, and this is in fact particularly advantageous because (as described further below) it greatly reduces the degree of undercutting of these leg portions as compared with a process wherein all of the depth of the between-leg portions is removed at one go.

Having thinned the second area of the blank the method of the invention results in a recess, or "well", being formed in the major face of the blank. The material forming the base of this recess will, in the second stage, be selectively removed to convert the base into the final, fragile area -which, in a lead-frame, is the assembly of inner leads. However, because this final form is so fragile it is desirable to support the whole area before the second stage removal is effected, and this is done, in the method of the invention, by filling the recess with a fixing material that will, as required, support and fix in place the thin material constituting the base of the recess. This fixing material can, naturally, be any appropriate to the circumstances -and, where it is not to be removed after the second stage material removal has occurred, but is to stay as a part of the final device (as is preferred where the device is a lead-frame), this fixing material will also be appropriate to the type of device. A lead-frame device is to be packaged with an electrically-insulating packaging material, conventional packaging materials are plastics (such as silica-filled expoxies like POLYSET 4I0B and NITTO HCI0 Type 2) and ceramics (such as alumina and beryllia), and clearly the fixing material should be compatible with the packaging material. Fixing materials compatible with one or other plastics packaging material are generally the thermo-setting resins, specifically the epoxies (such as those named above), while those compatible with one or other ceramics packaging material are generally glasses and glass-ceramics.

The recess formed in the blank is filled with fixing material, and may in fact be completely filled. However, it may also only be partly filled - either partly in depth, or partly in area. Indeed, in one preferred lead frame embodiment a central area of the recess, big enough to take the chip to which the lead frame will be connected, is left completely free of fixing material.

The actual mode of emplacement of the fixing material may be whatever is appropriate. For example, a fixing material that is a polymerised plastics might be "injected" or "squeezed" into place in the form of a pasty but flowable pre-polymer mixture (the final polymerisation then taking place in situ); a thermoplastics fixing material might even be "melted" into place. Similarly, a glassy fixing material might be likewise applied, in an un-fired form, and then fired in situ . Alternatively, a preformed block of material might be forced into place, possibly to be held there, securing the fragile area, with some glue. In one preferred case the fixing material is a glass-like lithium alumino-silicate, and is deposited in a glassy state and fired insitu to convert it to a glass-ceramic state.

As intimated above, the fixing material either may be removed at some later stage or may be left in place serving some useful function. An example of this latter with a lead-frame is the use of a fixing material that is "sticky", and helps to locate and secure the device in place in the resultant package.

Once the recess has been filled with the fixing material the remainder of the material to be removed from the blank in the second area is removed from the other major face. As in the case of the removal of blank material in the first stage, the removal technique may be any appropriate, as described above. The actual disposition of the material to be removed will also, naturally, be appropriate to the device being fabricated; for a lead-frame it is that material lying between the portions defining the inner leads. Moreover, as in the first stage, blank material can be removed not only from the second area but also from the first area. For example, to make a lead-frame half the thickness of first area material in the between-leg portions is removed (from one major face) in the first stage, and the rest -so separating the "legs" one from another -is removed (from the other major face) in the second stage.

Any "masking" techniques required, particularly to ensure registration of wanted and unwanted portions on one face with the corresponding wanted and unwanted portions on the other face, are well known, and need no comment here.

Having removed blank material in the second area both from one major face, and then, after supporting the base of the formed recess, from the other major face, the device is complete. If it is a lead-frame, for example, it can then be used -a chip can be mounted centrally of the second, fragile, area surrounded by the free ends of the fine inner leads, these leads can be connected (by wire-bonding, perhaps) to the relevant chip pads, the whole may then be encased in some suitable protector material (often by placing it in a small "box" sealed with a separate lid), but with the remains of the robust blank area -the "leg" portions -projecting therefrom and ready to be bent or otherwise mechanically shaped into the desired "leg" form. Alternatively, the lead-frame may be incorporated within an empty, chip-less open-top package (so that at some subsequent time the chip may be inserted into place and its pads connected up to the inner leads, and a lid attached and sealed shut). The process of making such a device is described hereinafter in more detail with reference to the accompanying Drawings and the Examples. It is here useful to note that the lead-frame as first constructed commonly has integrated therewith a whole series of strengthening and retaining members (some of which may be of a plastics, or other non-conducting substance), together with a series of test points conductively connected to the "leg" portions; some of these extra features of the lead-frame are removed once the completed chip-containing package has been made, while others are removed after the package and its contents have been tested.

The invention extends, of course, to a device, particularly a lead-frame, wherever fabricated by the method of the invention.

Various embodiments of the invention are now described, though by way of illustration only, with reference to the accompanying drawings in which:

Figures 1A, B, C and D form a sequence of perspective, diagrammatic, views showing symbolically the application of the method of the invention;

Figures 2A, B and C form another sequence of perspective, diagrammatic, views showing the various stages in the application of the inventive method to the fabrication of a leadframe.

Figures 3A, B and C show three "plan" views of three leadframe layouts before actual use; and

Figures 4A, B and C show respectively end elevation see-through, perspective and top-plan see-through views of a DIP employing a leadframe fabricated according to the invention.

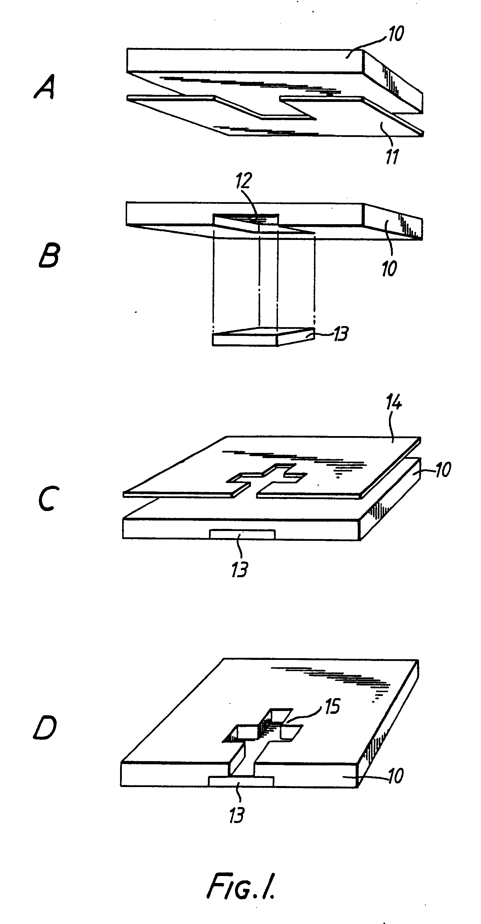

The sequence of operations illustrated by the Figures 1A, B, C and D series is generally as follows:

A) a planar, sheet-like blank (10) of leadframe material that is overall of a robust construction is protected on one surface (the undersurface, as viewed) with a mask (11) defining an area which is to be transformed into the required fragile area.

B) Blank material is then removed, through the mask, to a depth of roughly half the blank's thickness, so forming a recess (12) in the undersurface, and this recess is then filled with fixing material (13) that will support the fragile area formed in the final stage.

C) The upper surface (as viewed) of the leadframe blank is now protected with a second mask (14) defining the form of the required fragile area.

D) Blank material is then removed, through this second mask, right down to the fixing-material-filled recess 12, so forming the desired fragile area (15) supported by the fixing material 13.

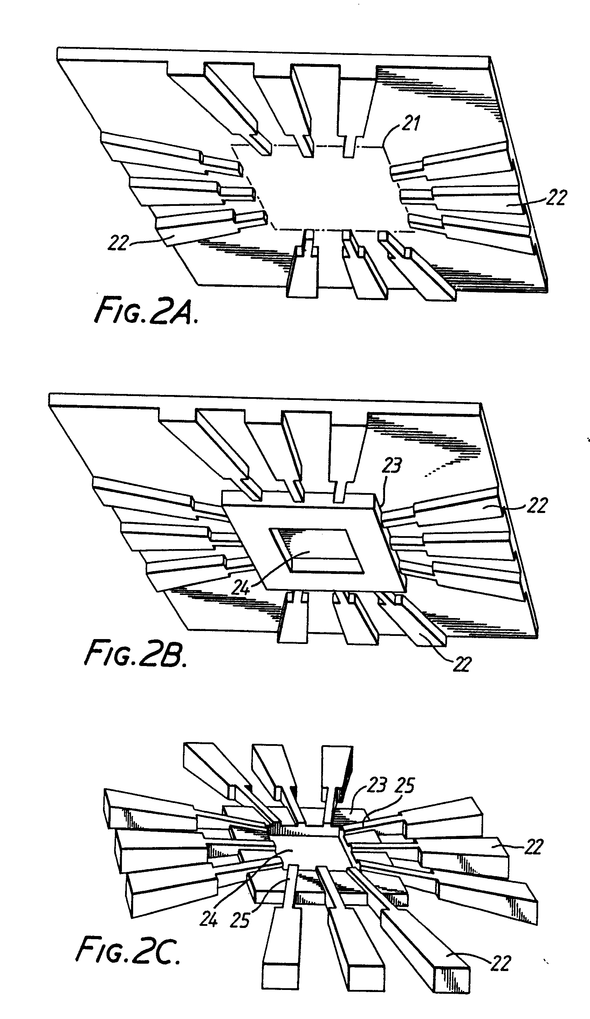

Figures 2A, B and C are a series of perspective views from below (A and B) and from above - (C) showing various stages in the formation of a leadframe. Figure 2A depicts the stage after removal of blank material from one major surface so as to make the recess in that surface. It is the base of that recess that will next be turned into the inner leads. At the same time as the recess is formed, there is removed half the thickness of the blank material elsewhere -the between-leg portion -so as to form in part the outer leads/legs of the desired leadframe.

Figure 2A shows the underneath (as viewed) of the blank after the recess (defined by the dashed line 21) has been formed and, at the same time, the portions between the eventual outer leads/legs have been removed leaving these outer leads (as 22) standing proud for roughly half their thickness. In Figure 2B there can be seen in place the fixing material (23), which takes the form of a square "ring" of material fitting snugly within the recess so as to leave a chip-sized central area - (24) unfilled (and thus the relevant part of the recess base unsupported). Finally, Figure 2C shows from above (as viewed) the leadframe after the remaining unwanted blank material has been removed. From this Figure it will be clear how the fragile inner leads (as 25) are safely supported by the ring of fixing material 23 while the outer leads 22 now stand free, and support themselves.

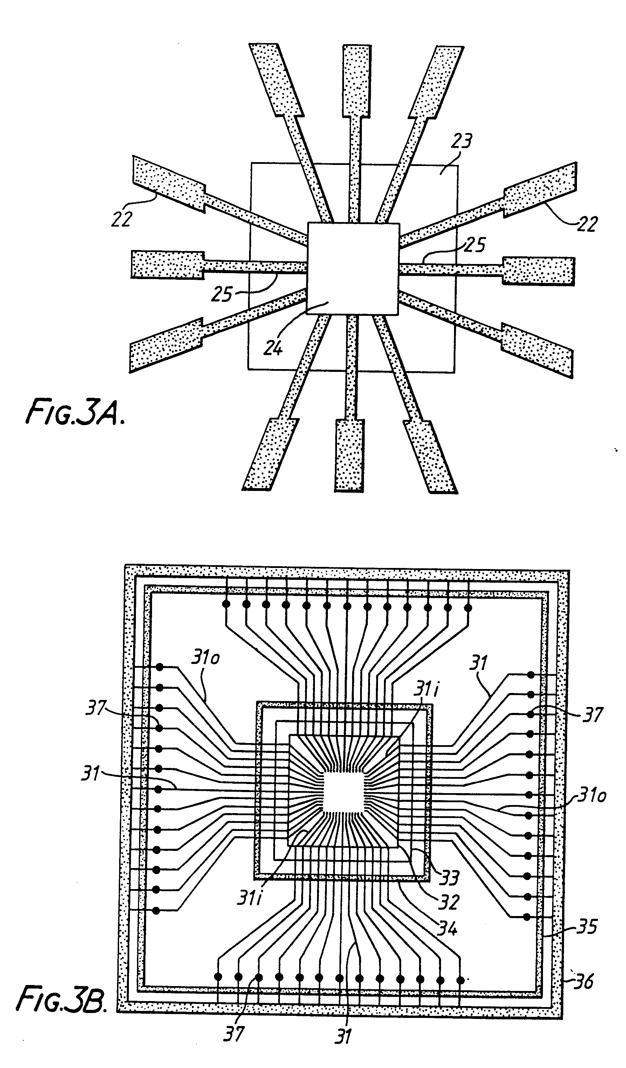

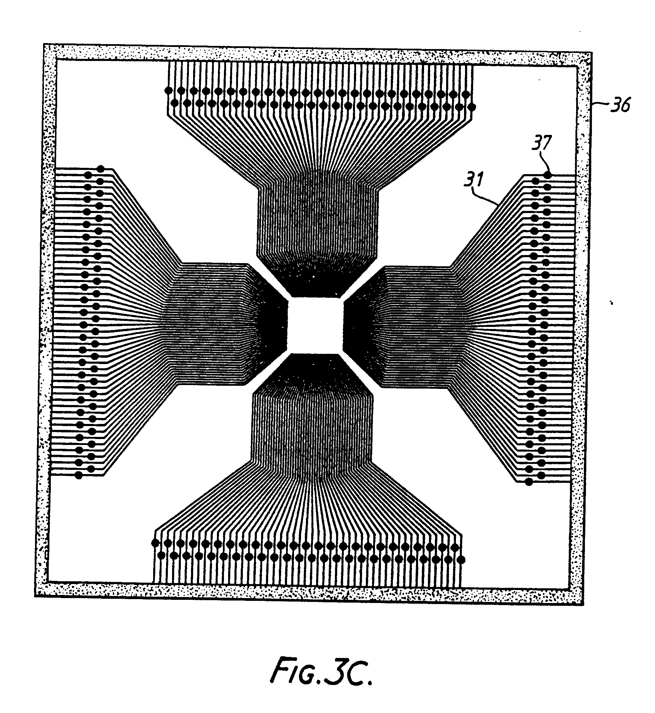

The views of Figures 3A, B and C top plan views of three different lead frames. That of Figure 3A corresponds to the leadframe of Figure 2C, that of Figure 3B relates to a yet more realistic leadframe, while that of Figure 3C is a slightly enlarged view of a real leadframe.

The leadframe of Figure 3B is a four-sided device with 13 leads (as 31) a side (making 52 leads in all). Each lead has a fine, fragile, inner portion - (as 3Ii) and a relatively robust outer portion (as 31 o). Within the general area of the inner leads 31ithere is a square ring-like lead support (of lead fixing material) whose inner edge is defined by the inner tips of the leads and whose outer edge is shown by the perimeter line (32). Further out from this perimeter is a line (33) indicating where the boundary of the package, forming the desired flat pack, will lie, and just beyond this is a first lead support ring (34) of a non-conductive plastics. Much beyond that, in the robust outer lead area, is a second non-conductive lead support ring (35), and beyond that still is a peripheral band of lead-frame blank material (36) temporarily holding the outer ends of the leads together in registration. Finally, just within the second support ring 35 each lead widens into a test contact portion (as 37).

The preparation of the leadframe of Figure 3B is as follows. First, from one major side of a blank, there is removed, to half the depth of the blank, all the material within the recess periphery (as defined by line 32) and elsewhere between the outer leads/legs, save for the outer ring 36. Next, the fixing-material inner ring (like 23 in Figure 3A) is placed in position. Then, all the rest of the between-lead blank material, over the entire surface, is removed from the other side. The finished leadframe may then be attached to the material which serves as the base of the flat pack. Finally, after possibly bending the leads into the shape required for use, the two support rings 34, 35 are placed in position.

At this stage, a chip may be mounted and connected up to the leadframe; the outer blank material ring 36 may be cut off, and the correct working of the chip tested by signals and power sent in and out via the test pads 37; a protective covering may be added; and finally the leads may be cut just outside the first support ring 34 and bent (if not already done) into the required shape for use.

Figure 3C shows, slightly enlarged, the lead layout of a real leadframe. It is comparable to Figure 3 B without the latter's two non-conductive support rings, but has 50 leads a side (making 200 leads in all).

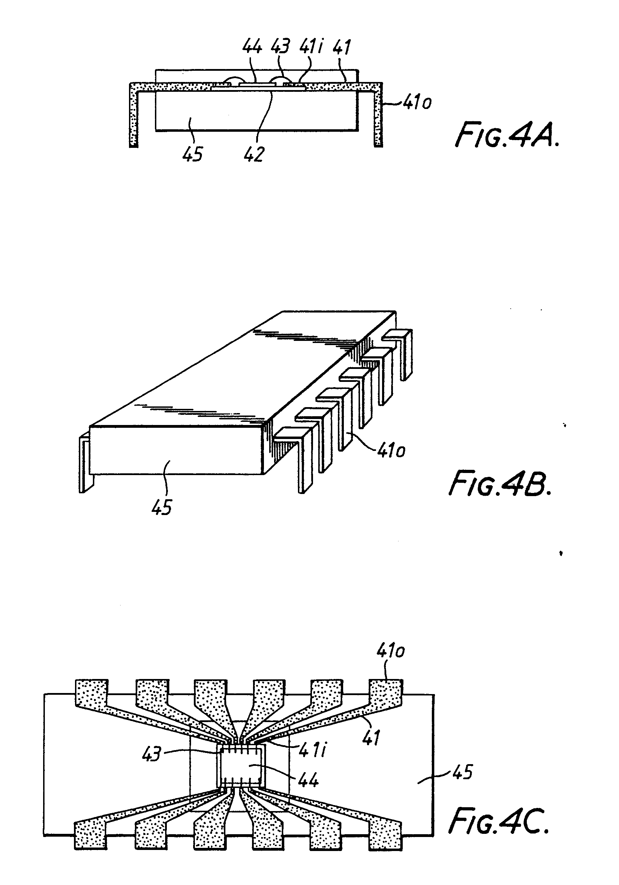

Finally, the sequence of Figures 4A, B and C shows various views of a simple Dual Inline Package using a leadframe fabricated in accordance with the invention. Figure 4B gives a general, perspective view from above, while Figures 4A and B are respectively a see-through end elevation and a see-through top plan. From these two see-through views it will be apparent that the leadframe has 12 leads (41; 6 on each of the two opposed long sides) that each have a fragile inner portion (4Ii) and a robust outer portion (4Io). The inner portions 4Ii are supported by a "slab" (42) of fixing material, and mounted on that, and connected by wires (as 43) to the inner portions 4Ii, is the chip (44). The whole is encased in a protective package (45), with the ends of the lead outer portions 4Io projecting therefrom to form legs.

The following Example is given, though again by way of illustration only, to show details of one preferred method of the invention.

Example: Preparation of a Leadframe

Stage I Preliminary preparation of the Leadframe

In the normal way a 0.1mm sheet of NILO K (an alloy of 54wt% iron 29wt% nickel and 17wt% cobalt) was cut to size, pierced with the requisite tooling/locating apertures, and then vapour degreased to remove its oily protective coating. The surface was then de-oxidised and slightly roughened (abraded) by passing it through a conventional pumice jet scrubber.

Stage 2 First masking and etching

Using a standard dry film resist laminator, a 0.025mm layer of a UV-sensitive photo-resist - (Dupont's RISTON, a polyvinyl-glycidyl acrylate) was applied to each side of the blank. The coated blank was then located in an imager (a Dupont PC Printer Lightbox), and exposed for a suitable intensity/time to UV light through an appropriate artwork master mask, causing partial polymeration of the unshielded resist layer areas. After removal of the unexposed (unpolymerised) resist, by passing the blank through a resist developer containing CHLOROTHENE (a trichloroethane-based solvent), the remaining resist was baked at 80°C (to complete the polymerisation).

The thus-masked blank was then spray etched, using a conventional ferric chloride etchant at 30°C for sufficient time (a few minutes) to allow the etchant to penetrate about 0.05mm -half the blank thickness -into the blank material. After washing, the remaining resist was then removed by passing the blank through a bath of SYNSTRYP solvent - (based on dichloromethane).

At this stage the blank had a partial lead pattern - only the larger outer leads -together with a central recess covering the area of the very much finer inner leads etched on one side (the "inner" side) to a depth halfway through the material.

## Stage 3 Glassing the central recess

In order to enhance the adhesion of the subsequent glass material to the leadframe, a "furnace oxide" coating was then formed on the blank surface by heating the blank in nitrogen with some oxygen in a belt furnace to around 900°C over a period of half an hour. Then, using a graphite frame to locate and contain it, a finely powdered lithium alumino-silicate glass was applied to the central recessed area of the blank, and fixed into place by fusing in a furnace to about 900°C.

## Stage 4 Second masking and etching

After deoxidising the blank (by a 5 minute dip in 50% hydrochloric acid at 65°C), the techniques described in Stage 2 above were used to form a photoresist coating on the non-glassed surface, convert this into an appropriate etch-resistant mask (the glassed surface was additionally given an etch-resistant coating of Robertons Chemicals' Resist 1993, an air-drying liquid resist), etch away the unwanted blank material (so defining both the "top" half of the large outer leads, and the entire depth of the very much finer inner leads), and remove the residue of the photoresist coating. The result was the desired leadframe, having large, self-supporting outer leads having a depth equal to that of the original blank and being integral with the glass-supported fine inner leads having half that depth.

## Claims

I. A method of fabricating a generally planar, sheet-like, device having a first, robust, area and, contiguous therewith, a second, fragile, area to be constructed by removal of some of the material of which the device consists, in which method:

a) starting with a corresponding generally planar, sheet-like blank, in which both first and second areas are robust, some of the material to be removed from the blank to make the second, fragile, area is so removed from one major face of the blank, to form a recess in the blank;

b) the thus-formed recess is filled with a fixing material, so as to support and fix in place the thin area of blank material constituting the base of the recess; and thereafter

c) the remainder of the material to be removed from the blank to make the second, fragile, area is so removed from the other major face of the blank, so forming the required second, fragile, area supported and fixed by the fixing material and contiguous with the first, robust, area.

2. A method as claimed in Claim I, applied in the fabrication of a lead-frame.

3. A method as claimed in either of the preceding Claims, in which, where the device is a lead-frame, the material of which the blank is constituted is a nickel-iron alloy, or copper or a copper-based alloy.

4. A method as claimed in any of the preceding Claims, in which, where the device is a lead-frame, the "robust" area ends up as the "legs" of the final package, tough enough to withstand handling, while the "fragile" area ends up as extremely fine conductors a hundred or so microns in width.

5. A method as claimed in any of the preceding Claims, in which, where the device is a lead-frame, material is removed both simply to "thin" the sheet over the whole of the defined, second area, so that it becomes more suitable for forming into the inner leads of the lead-frame, and from between those portions that are to be the leads, so separating each lead from its neighbours; in the first stage the blank is thinned, from one of its major faces, to roughly half its original thickness, while in the second stage the remaining between-lead blank material is removed from the other major face, so leaving the formed leads flush with this other major face.

6. A method as claimed in any of the preceding Claims, in which the removal of material from the blank is accomplished by a chemical etching technique.

7. A method as claimed in any of the preceding Claims, in which, in the first stage, material is removed both from all over the whole of the second area of the blank (that area destined to become the fragile area of the device), so thinning that area, and at the same time from the first area - (the area destined to become the robust area of the device).

8. A method as claimed in Claim 7, in which, where the device is a lead-frame, the robust area material between those portions destined to be the outer part of the leads is removed at the same time as the second area is thinned.

9. A method as claimed in any of the preceding Claims, in which, where the device is a lead-frame, the fixing material is a silica-filled epoxy or a glass or glass-ceramic.

l0. A method as claimed in any of the preceding Claims, wherein, where the device is a lead-frame, a central area of the recess, big enough to take the chip to which the lead-frame will be connected, is left completely free of fixing material.

II. A method as claimed in any of the preceding Claims, in which, where the device is a lead-frame, the material removed from the other major face is both that material lying between the portions defining the inner leads and the remainder of the thickness of first area material in the between-leg portions.

12. A lead-frame wherever fabricated by a method as claimed in any of the preceding claims.

A

B

C

D

Fig. 1.

FIG.2A.

FIG.2B.

FIG.2C.

FIG.3A.

FIG.3B.

FIG. 3C.

44  43  41i  41

45    42

*FIG.4A.*

410

410

45

*FIG.4B.*

410

43    41i

44

41

45

*FIG.4C.*